# FASCICULE DE BREVET EUROPEEN

(11) **EP 2 828 635 B1**
(45) Date de publication et mention de la délivrance du brevet: **30.05.2018**
(21) Numéro de dépôt: 13715306.0
(22) Date de dépôt: 12.03.2013
(51) Int. Cl.: G01N 3/06, G01B 11/14

(54) **SYSTÈME DE MESURE D'UNE ZONE D'ÉCARTEMENT DANS UN SUBSTRAT**
SYSTEM ZUR MESSUNG EINER TRENNZONE BEI EINEM SUBSTRAT
SYSTEM FOR MEASURING A ZONE OF SEPARATION IN A SUBSTRATE

(30) Priorité: 21.03.2012 FR 1252507
(43) Date de publication de la demande: 28.01.2015
(73) Titulaire: Commissariat à l'Énergie Atomique et aux Énergies Alternatives, 75015 Paris (FR)
(72) Inventeur: MAZEN, Frédéric, F-38100 Grenoble (FR); RIEUTORD, François, F-38120 Saint Egreve (FR); PENOT, Jean-Daniel, 73000 Chambéry (FR); MONTMAYEUL, Philippe, F-38190 Bernin (FR)
(74) Mandataire: Delorme, Nicolas
(86) Numéro de dépôt international: PCT/FR2013/050517
(87) Numéro de publication internationale: WO 2013/140065

(56) Documents cités:
- EP-A1- 0 356 563
- JP-A- 61 149 839
- G W WEIDMANN ET AL: "Interferenzoptische Vermessung der Craze-Zone vor der Rißspitze in PMMA unterschiedlichen Molekulargewichtes", COLLOID AND POLYMER SCIENCE, vol. 254, no. 2, 28 février 1976 (1976-02-28), pages 205-214, XP055050165, ISSN: 0303-402X, DOI: 10.1007/BF01517034
- SUZUKI S ET AL: "Pulsed holographic microscopy as a measurement method of dynamic fracture toughness for fast propagating cracks", JOURNAL OF THE MECHANICS AND PHYSICS OF SOLIDS, PERGAMON PRESS, OXFORD, GB, vol. 36, no. 6, 1 janvier 1988 (1988-01-01), pages 631-653, XP024469166, ISSN: 0022-5096, DOI: 10.1016/0022-5096(88)90002-6 [extrait le 1988-01-01]
- ROGER P KAMBOUR: "Mechanism of fracture in glassy polymers. III. Direct observation of the craze ahead of the propagating crack in poly(methyl methacrylate) and polystyrene", JOURNAL OF POLYMER SCIENCE PART B: POLYMER PHYSICS, vol. 4, no. 3, 30 juin 1966 (1966-06-30), pages 349-358, XP055050285, ISSN: 0887-6266, DOI: 10.1002/pol.1966.160040305
- KOIZUMI H ET AL: "OPTICAL MEASUREMENT OF CRACK PROPAGATION WITH HIGH RESOLUTION", REVIEW OF SCIENTIFIC INSTRUMENTS, AIP, MELVILLE, NY, US, vol. 64, no. 7, 1 juillet 1993 (1993-07-01), pages 1822-1824, XP000387118, ISSN: 0034-6748, DOI: 10.1063/1.1144017
- K M LIECHTI ET AL: "Crack propagation at material interfaces: I. Experimental technique to determine crack profiles", EXPERIMENTAL MECHANICS, vol. 22, no. 7, 1 juillet 1982 (1982-07-01), pages 262-269, XP055050278, ISSN: 0014-4851, DOI: 10.1007/BF02326391

## Description

La présente invention concerne un système de mesure de la propagation d'une zone d'écartement entre une première portion et une deuxième portion d'au moins un substrat. De plus, la présente invention concerne un dispositif adapté à la propagation de cette zone d'écartement. Enfin, la présente invention concerne un procédé de mesure de la propagation de cette zone d'écartement.

Certains procédés industriels sont basés sur la fracture d'un substrat de matériau fragile tel que:
- le procédé Smart Cut™, qui permet de détacher un film mince d'un substrat par rupture du matériau, la rupture étant induite par implantation d'espèces ioniques gazeuses dans le substrat,
- les processus de clivage pour séparer différentes parties sur une plaquette de matériau aussi appelée 'wafer' dans la terminologie anglo-saxonne.

Le contrôle de la vitesse de fracture et plus généralement de la dynamique de fissuration est nécessaire car souvent le faciès de rupture, c'est-à-dire la rugosité des surfaces du matériau fracturé est conditionné par les aspects dynamiques de la propagation du front de fracture.

Par ailleurs, il peut être utile de contrôler la façon dont une rupture se propage dans un matériau afin par exemple de pouvoir prédire ou imposer un trajet de rupture.

L'observation de la fracture peut être obtenue par des jauges de rupture. Ces jauges sont constituées d'un petit réseau de fils placé sur le trajet prévu de la fissure qui se brisent en même temps que le matériau lors du passage du front de fracture. Mais ce réseau est collé sur un coté latéral du substrat à fracturer si bien que la vitesse de l'ouverture est uniquement mesurée sur ce même coté du substrat. Cette technique ne donne donc qu'une information sur une vitesse locale. Par ailleurs, le collage du réseau au substrat peut conduire à perturber la propagation de l'onde de fracture.

La méthode de la photographie rapide permet également d'observer l'avancée du front de fissure à partir d'une face latérale du substrat. Cette méthode est efficace lors de la fracture de matériaux relativement mous et transparents. Des effets élasto-optiques peuvent d'ailleurs être combinés avec la photographie rapide afin d'obtenir une information sur le champ de contrainte au voisinage du front de fissure. Cependant, lorsque la fissure d'un substrat centimétrique se déplace à une vitesse de quelques km/s, par exemple de 1 à 4 km/s pour une fracture dans le silicium, il est nécessaire d'utiliser des fréquences de l'ordre d'un million d'images par seconde. Cette fréquence est extrêmement difficile à atteindre et est très coûteuse. Par ailleurs, seuls les matériaux transparents à la lumière visible sont utilisables pour une caractérisation du plan entier de fracture.

Il existe également des méthodes d'observation du faciès de rupture de la surface des substrats fracturés mais ces méthodes limitent la possibilité d'étudier le chemin et la vitesse de la fissure après le passage de la fracture.

De la même façon, pour certains procédés industriels, il peut aussi être intéressant d'étudier la façon dont deux surfaces de matériau se rapprochent. L'observation d'une onde de collage relativement lente, dont la vitesse est par exemple comprise entre quelques mm/s à quelques cm/s, est habituellement faite à l'aide de caméras. Mais pour certains collages, notamment pour un collage direct sous vide, l'onde de collage se propage très rapidement, par exemple avec une vitesse de l'ordre de quelques km/s. Or, les méthodes actuellement à disposition et qui restent bon marché ne permettent pas caractériser une onde de collage de cet ordre de vitesse.

L'article de Weidman et Döll, Colloid & Polymer Sci. 254, 205-214 (1976) divulgue un procédé de mesure d'une fissure avec un microscope et une camera qui enregistrent la propagation des franges d'interférence d'une fissure illuminée. L'article divulgue donc aussi un système de mesure de la propagation d'une zone d'écartement entre une première portion et une deuxième portion d'au moins un substrat, le système comprenant: un module d'émission d'au moins un faisceau incident illuminant une région du substrat, ledit module d'émission étant agencé de sorte que le faisceau incident peut traverser la première portion, la zone d'écartement et rencontrer la deuxième portion, de manière à générer au moins un premier faisceau émergent provenant de l'interface entre la première portion et la zone d'écartement, et au moins un deuxième faisceau émergent provenant de l'interface entre la zone d'écartement et la deuxième portion et un module de détection d'intensité lumineuse, agencé de sorte à détecter les valeurs d'intensité lumineuse résultante en un point donné de l'interférence entre les premier et deuxième faisceaux émergents. Un des buts de l'invention est de pallier à un ou plusieurs de ces inconvénients. A cet effet, et selon un premier aspect, l'invention a pour objet un système de mesure de la propagation d'une zone d'écartement C entre une première portion et une deuxième portion d'au moins un substrat, le système comprenant :
- un module d'émission d'au moins deux faisceaux incidents Fi spatialement distincts illuminant chacun une région du substrat, ledit module d'émission étant agencé de sorte que les au moins deux faisceaux incidents Fi peuvent traverser la première portion, la zone d'écartement C et rencontrer la deuxième portion, de manière à générer chacun au moins un premier faisceau émergent Fe provenant de l'interface entre la première portion et la zone d'écartement C, et au moins un deuxième faisceau émergent Fe provenant de l'interface entre la zone d'écartement C et la deuxième portion,
- un module de détection d'intensité lumineuse, agencé de sorte à détecter les valeurs d'intensité lumineuse résultante en un point donné de l'interférence entre les premier et deuxième faisceaux émergents Fe,
- un calculateur agencé pour déterminer au moins un paramètre représentatif des conditions de la propagation de la zone d'écartement C à partir des variations temporelles de l'intensité lumineuse détectées par le module de détection.

Dans la présente demande, par l'expression 'une zone d'écartement C entre une première portion et une deuxième portion', on entend la zone s'étendant entre ces deux portions et pouvant prendre la forme d'un dièdre formé à partir du point de contact entre les surfaces de la première portion et de la deuxième portion.

Dans la présente demande et dans le cadre du collage entre une première et une seconde portion, on entend par l'expression 'propagation d'une zone d'écartement', le déplacement de la zone d'écartement C devant la propagation du collage du fait du rapprochement des surfaces des deux portions.

Dans la présente demande et dans le cadre de la fracture, par l'expression 'propagation d'une zone d'écartement' on entend l'avancement de la zone d'écartement C derrière le passage du front de fracture du fait de l'éloignement des surfaces entre les deux portions du substrat.

Par l'expression 'un faisceau qui peut rencontrer la deuxième portion', on entend un 'faisceau qui peut illuminer la deuxième portion' que le faisceau soit réfléchi ou partiellement transmis à travers la deuxième portion.

Ce dispositif est simple à mettre en place, peu coûteux et permet de mesurer des vitesses très rapides de propagation d'une zone d'écartement C, ce qui est particulièrement utile lors d'observation de portions en matériaux fragiles, de fortes raideurs tel que le silicium et des céramiques par exemple. De plus, ce dispositif est très sensible car il permet de mesurer de très faibles épaisseurs de zone d'écartement C entre les deux portions, de l'ordre par exemple de quelques fractions de longueur d'onde. Le système de mesure peut ainsi détecter l'instant exact auquel la fracture ou le collage a lieu. Par ailleurs, ce dispositif est très précis car il permet de déterminer le profil d'écartement ou de rapprochement entre les deux portions par l'intermédiaire de mesures interférométriques. Il permet également de réaliser une mesure sans contact, sans altérer le(s) substrat(s) à étudier.

Par l'expression 'au moins deux faisceaux spatialement distincts' on entend des faisceaux dont les trajets ne sont pas confondus de sorte qu'ils illuminent chacun une région localisée de la surface du substrat. Les régions illuminées sont distinctes et peuvent alors être situées à différents endroits sur l'ensemble de la surface du substrat.

De préférence, le module de détection et le calculateur sont configurés pour déterminer des vitesses de propagation de la zone d'écartement C entre les première et deuxième portions. Le système est ainsi capable de mesurer des vitesses très rapides de propagation de la zone d'écartement C devant la propagation du collage entre les première et deuxième portions du substrat ou derrière le front de fracture entre les première et deuxième portions du substrat (de l'ordre de quelques km/s par exemple).

Selon un mode de réalisation particulier, les au moins deux faisceaux incidents illuminent chacun une région du substrat tout en étant situés dans des plans différents. Cet arrangement de faisceaux non coplanaire permet la détection de l'apparition et la mesure de la vitesse de la propagation de la zone d'écartement C entre différents points répartis sur l'ensemble de la surface du substrat.

Avantageusement, les au moins deux faisceaux incidents sont arrangés de sorte à être coplanaires afin de permettre la mesure de la propagation de la zone d'écartement C selon la direction du plan des faisceaux.

Cet arrangement est favorable à la détermination du profil d'écartement entre les première et deuxième portions lors de la fracture entre les première et deuxième portions ou le profil de rapprochement lors du collage des première et deuxième portions. Il est ensuite possible de déterminer l'intensité et la variation des contraintes soumises sur les portions du substrat au cours de la fracture ou du collage et également d'étudier et de déterminer les mécanismes entrant en jeu.

Selon un mode particulier de réalisation de l'invention, le module d'émission comprend au moins deux sources lumineuses adaptées à émettre des faisceaux. Il est ainsi possible de facilement modifier la distance entre les faisceaux incidents ou leur orientation par simple déplacement des sources lumineuses. Ceci permet également de faciliter l'addition ou le retrait d'une source lumineuse selon la taille du substrat à observer.

De préférence, le module d'émission comprend une source lumineuse et au moins un coupleur (coupler en anglais), la source lumineuse et ledit au moins un coupleur étant agencés de sorte que ledit au moins un coupleur peut séparer la lumière émise par la source lumineuse en au moins deux faisceaux.

Avantageusement, le module d'émission comprend au moins deux fibres optiques monomodes et au moins deux collimateurs, les fibres optiques étant adaptées à guider les faisceaux produits par ledit au moins un coupleur respectivement jusqu'aux collimateurs, les collimateurs étant adaptés à produire les au moins deux faisceaux incidents. Ainsi, les faisceaux incidents sont guidés sans étalement du signal jusqu'aux collimateurs qui permettent d'émettre un faisceau de rayons de lumière parallèles. Cet agencement permet d'éloigner la source lumineuse de la zone de mesure.

Selon une réalisation possible, la source lumineuse est monochromatique, et comprend notamment un laser, tel qu'une diode laser infrarouge adaptée pour le cas d'un substrat de silicium.

Avantageusement, le module d'émission est agencé pour générer au moins deux faisceaux incidents Fi monochromatiques, cohérents et intenses de sorte que l'intensité lumineuse détectée soit supérieure au bruit de la mesure de détection. Typiquement, la puissance lumineuse du faisceau est supérieure à 0,1 mW et avantageusement supérieure à 0,5, voire 1mW.

De préférence, au moins un faisceau incident est sélectionné de sorte qu'au moins 10% de son intensité lumineuse peut être transmise à travers la première portion de sorte à conserver une intensité lumineuse suffisante pour finement observer la variation de réflexion et/ou transmission lorsque le faisceau traverse la zone d'écartement C.

Selon un mode de réalisation particulier, le module d'émission et le module de détection sont agencés du même coté dudit au moins un substrat de sorte à détecter les faisceaux émergents lorsque le système de mesure fonctionne en réflexion, notamment lorsque les faisceaux incidents sont réfléchis par la deuxième portion.

Avantageusement, ledit au moins un faisceau incident est également sélectionné de sorte qu'au moins 10% de son intensité lumineuse peut être transmise à travers la deuxième portion rencontrée par ledit au moins un faisceau incident de sorte que le module d'émission et le module de détection sont agencés de part et d'autre dudit au moins un substrat. Il est ainsi possible de détecter les faisceaux émergents lorsque le dispositif fonctionne en transmission. De plus, grâce à cette configuration, plusieurs substrats peuvent être placés de façon parallèles et de sorte que leurs surfaces principales soient perpendiculaires à la direction des faisceaux incidents. Les faisceaux peuvent alors traverser l'ensemble des substrats. Il est ainsi possible de mesurer la propagation des zones d'écartement dans les substrats en une seule étape de mesure.

Typiquement, la longueur d'onde dudit au moins un faisceau incident est sélectionnée de sorte qu'au moins 10% de son intensité lumineuse peut être transmise à travers la deuxième portion et/ou à la première portion.

De préférence, le module de détection comprend au moins un récepteur d'intensité lumineuse et au moins un photodétecteur de sorte à convertir les valeurs reçues d'intensité lumineuse résultante en un point donné de l'interférence entre les premier et deuxième faisceaux en signal électrique.

Selon une possibilité, le système de mesure comprend des moyens d'acquisition et d'enregistrement du signal électrique, tel qu'un dispositif d'échantillonnage, par exemple un oscilloscope numérique ou une carte de conversion analogique numérique, de sorte à pouvoir stocker les informations servant notamment de base au calcul de la vitesse de la propagation de la zone d'écartement C par le calculateur.

Typiquement, le calculateur comprend un processeur.

Selon une possibilité, les moyens d'acquisition et d'enregistrement du signal électrique sont intégrés au calculateur.

Selon un deuxième aspect, l'invention a pour objet un dispositif adapté à la propagation d'une zone d'écartement C entre une première portion et une deuxième portion d'au moins un substrat, le dispositif comprenant une banc de mesure, tel qu'un four, une machine de traction ou une machine d'essai mécanique, équipé de moyens adaptés à l'induction d'une fracture ou d'un collage entre la première portion et la deuxième portion et un système de mesure de la propagation d'une zone d'écartement C, tel que précédemment décrit. Ce dispositif permet ainsi de mesurer in situ des paramètres représentatifs des conditions de la propagation de la zone d'écartement C sur le banc de mesure permettant la fracture ou le collage entre les deux portions. Ces paramètres sont par exemple la détection de l'apparition de la fracture ou du collage, la vitesse du front de fracture ou du front de collage et le profil d'écartement ou de rapprochement entre les deux portions. Ce profil d'écartement prend une valeur de plus en plus importante dans le cas de la fracture et une valeur de plus en plus petite, jusqu'à devenir nulle lors du collage. Une fois traitées, ces informations permettent de déterminer les phénomènes intervenant lors de fracture ou du collage, telles que les contraintes subies dans le matériau et le mécanisme de fracture ou de collage.

Selon une possibilité, le banc de mesure est une enceinte fermée, notamment un four étanche de sorte à pouvoir induire une fracture et/ou un collage sous vide.

Selon un troisième aspect, l'invention a pour objet un procédé de mesure de la propagation d'une zone d'écartement C entre une première portion et une deuxième portion d'au moins un substrat, le procédé comprenant les étapes suivantes :
- émettre au moins deux faisceaux incidents, spatialement distincts illuminant chacun une région du substrat de sorte à générer chacun au moins un premier faisceau émergent provenant de l'interface entre la première portion et la zone d'écartement C, et au moins un deuxième faisceau émergent provenant de l'interface entre la zone d'écartement C et la deuxième portion,
- détecter les valeurs d'intensité lumineuse résultante en un point donné de l'interférence entre les premier et deuxième faisceaux émergents à une première position de détection,
- détecter les valeurs d'intensité lumineuse résultante en un point donné de l'interférence entre les premier et deuxième faisceaux émergents à une deuxième position de détection,
- mesurer la différence de temps entre un premier instant de détection de l'apparition de la zone d'écartement C au niveau de la première position de détection et un deuxième instant de détection de l'apparition de la zone écartement C au niveau de la deuxième position de détection, et
- déterminer la vitesse de propagation de la zone écartement C entre les première et deuxième portions dudit au moins un substrat en fonction de la différence de temps entre les premier et deuxième instants de détection et de la distance entre les première et deuxième positions de détection.

Ce procédé permet ainsi de facilement observer in situ la propagation très rapide d'une zone d'écartement C entre deux portions d'un substrat lors d'une fracture ou d'un collage. L'utilisation des signaux lumineux d'un faisceau émergent du substrat permet une grande finesse et précision des mesures.

Avantageusement, les surfaces des première et deuxième portions sont polies double face de sorte à limiter la diffusion des faisceaux.

De préférence, le procédé comprend une étape consistant à sélectionner au moins un faisceau incident de sorte qu'au moins 10% de son intensité lumineuse peut être transmise à travers la première portion traversée.

Selon une possibilité, le procédé comprend en outre une étape consistant à détecter l'apparition de la zone d'écartement C dans le substrat par une variation temporelle de l'intensité lumineuse. La détection de l'apparition de la zone d'écartement C étant réalisée à l'échelle de quelques fractions de longueur d'onde optique, elle permet de mesurer de très faibles épaisseurs d'ouverture.

Ce procédé permet également si l'on connait le lieu et l'instant d'initiation du collage ou de la fracture de déterminer la vitesse de propagation de la zone d'écartement C en fonction de la distance entre le lieu d'initiation du collage ou de la fracture et le point détection et le temps entre le moment de déclenchement de la fracture ou du collage et celui de détection.

Avantageusement, le procédé comprend en outre une étape consistant à déterminer le temps écoulé entre au moins deux maximums consécutifs de l'intensité lumineuse détectée par un module de détection de sorte à déterminer la vitesse de la propagation de la zone d'écartement C entre les première et deuxième portions. Cette détermination est très précise car elle utilise une mesure interférométrique. Le profil d'écartement ou de rapprochement entre les deux portions est obtenu à une position déterminée par la position de photodétecteur considéré. Le profil peut être obtenu pour chacune des positions des photodétecteurs utilisés. Il est ainsi possible si différents systèmes sont utilisés de déterminer le profil dynamique de collage ou de fracture.

Selon un mode particulier de réalisation de l'invention, le procédé comprend les étapes suivantes
- mettre en oeuvre plusieurs substrats transmettant au moins 10% de l'intensité lumineuse des faisceaux émis Fi, et émettre au moins un faisceau incident de sorte à ce qu'il traverse chaque première portion, chaque deuxième portion et chaque zone d'écartement C.

De la sorte, il est possible de détecter l'apparition d'une zone d'écartement C, la vitesse de propagation de la zone d'écartement C et le profil d'écartement entre la première et deuxième portion de plusieurs substrats en une seule étape d'acquisition de données.

D'autres aspects, buts et avantages de la présente invention apparaîtront mieux à la lecture de la description suivante de différents modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Des traits pointillés symbolisent une première et une deuxième portions d'un substrat délimitées par un plan de fragilisation. Dans la suite de la description, par souci de simplification, des éléments identiques, similaires ou équivalents des différentes formes de réalisation portent les mêmes références numériques.
- La figure 1 est une illustration schématique d'un système de mesure selon un mode de réalisation de l'invention.
- La figure 2 est illustration schématique de signaux électriques obtenus par différents photodétecteurs selon un mode de réalisation de l'invention.
- La figure 3 est une illustration schématique d'une partie d'un système de mesure pour un fonctionnement dans un mode de réflexion selon un mode de réalisation de l'invention.
- La figure 4 est une illustration schématique d'un système de mesure pour lequel la mesure est effectuée sur plusieurs substrats selon un mode de réalisation de l'invention.

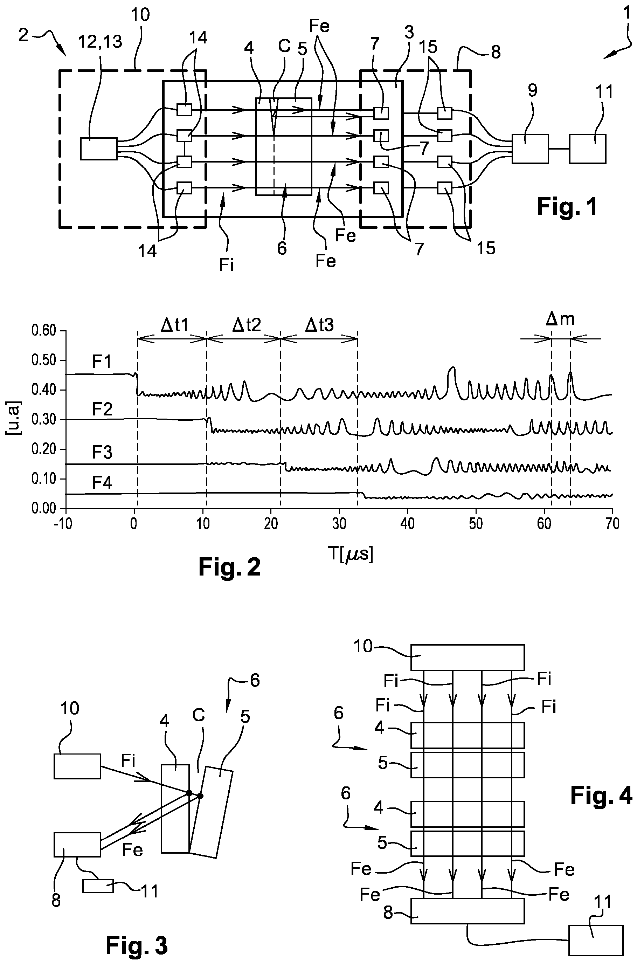

La figure 1 illustre un dispositif 1 adapté à la propagation d'une zone d'écartement C comprenant un système de mesure 2 de la propagation de la zone d'écartement C et un banc de mesure 3, équipé de moyens notamment adaptés à l'induction d'une fracture entre une première portion 4 et une deuxième portion 5 d'un substrat 6, par exemple en silicium. Le banc 3 peut être par exemple une enceinte de fracture, tel qu'un four.

Le système de mesure 2 comprend un module d'émission 10 de quatre faisceaux incidents Fi adaptés à traverser une deuxième portion 5 et/ou une première portion 4 formant un substrat 6 placé dans l'enceinte 3. Le système de mesure 2 comprend également un module de détection 8 comportant des récepteurs 7 pour recevoir et détecter des faisceaux émergents Fe. Le module de détection 8 comprend également des photodiodes 15 qui convertissent les signaux optiques reçus par les récepteurs 7 en courant électrique. Le système de mesure 2 comprend enfin des moyens d'acquisition et d'enregistrement 9 des signaux et un calculateur 11 adapté à déterminer des paramètres de la dynamique de la propagation de la zone d'écartement C entre la première portion 4 et la deuxième portion 5 du substrat 6.

Il est à noter que le système de mesure 2 tel qu'illustré à la figure 1 est présenté pour un fonctionnement dans un mode de transmission c'est-à-dire que le module d'émission 10 et le module de détection 8 sont placés en regard, de part et d'autre du substrat 6. Ce fonctionnement en transmission n'est adapté que lorsque les deux portions 4,5 du substrat 6 sont suffisamment transparentes aux faisceaux, c'est-à dire qu'ils transmettent au moins 10% de l'intensité lumineuse des faisceaux Fi.

Le module d'émission 10 est constitué d'une source lumineuse 12 apte à émettre un faisceau monochromatique, cohérent et intense, telle qu'une diode laser infra rouge. Un générateur non illustré permet de piloter la diode laser infrarouge 12 transparente pour le silicium.

Puis, le module d'émission 10 comprend successivement, suivant la direction du trajet optique parcouru par les faisceaux, un coupleur 13 qui divise la lumière émise par la diode laser 12 en quatre faisceaux monochromatiques. Quatre fibres optiques monomodes acheminent ces faisceaux respectivement jusqu'à quatre collimateurs 14, placés dans l'enceinte 3 permettant la fracture. Les faisceaux incidents Fi produits par les collimateurs 14 sont parallèles et coplanaires. Des faisceaux incidents Fi peuvent également ne pas être coplanaires. Ils peuvent être émis vers différents points répartis sur l'ensemble de la surface principale du substrat 6.

Une nacelle adaptée à la fracture (non illustrée) est disposée dans l'enceinte 3 pour y insérer le substrat 6 de sorte que les quatre faisceaux incidents Fi peuvent traverser les deux portions 4,5 du substrat 6 transparent ainsi que le plan de fragilisation. Un module de détection 8 comprenant quatre récepteurs 7 et quatre photodétecteurs 15 est placé symétriquement aux collimateurs 14 de sorte à recevoir les faisceaux émergents Fe du substrat 6. Dans l'exemple, quatre fibres optiques, par exemple monomodes ou multi modes sont prévues pour transmettre les signaux optiques à l'extérieur de l'enceinte 3, jusqu'à quatre photodétecteurs 15, telles que des photodiodes. Les photodétecteurs 15 sont adaptés à convertir les valeurs d'intensité lumineuse des quatre faisceaux émergents Fe reçus par les quatre récepteurs 7 en signaux électriques pour les transmettre à des moyens d'acquisition et d'enregistrement 9, tel qu'un oscilloscope numérique, par l'intermédiaire de câbles électriques. Un câble de liaison permet la transmission des informations enregistrées pour un traitement avec un calculateur 11, tel qu'un processeur. Dans une variante non représentée, les moyens d'acquisition et d'enregistrement 9 sont intégrés au calculateur 11.

Dans un mode de réalisation non illustré, l'ensemble des éléments composant le module d'émission 10 et le module de détection 8 sont tous placés dans l'enceinte 3.

Un premier exemple de fonctionnement du système de mesure 2 est maintenant décrit pour la mesure de la fracture d'un substrat 6 composé de deux portions 4,5 de silicium. Ces deux portions 4,5 sont délimitées par un plan de fragilisation obtenu au préalable par implantation d'espèces ioniques dans le substrat 6 et au niveau duquel la fracture peut être induite par exemple par traitement thermique, éventuellement assisté d'une action mécanique telle que l'insertion d'une lame. D'autres origines de fragilisation peuvent être utilisées pour l'obtention d'un clivage dans un tel substrat 6.

La longueur d'onde d'émission de la diode laser 12 est choisie pour être supérieure à 1100 nm, et par exemple égale à 1310 nm de sorte à pouvoir traverser les portions 4,5 de silicium. En effet, le silicium est un matériau transparent à ces longueurs d'onde. Il peut transmettre plus de 10% de l'intensité lumineuse du faisceau d'une telle longueur d'onde. Dans l'exemple, la puissance de la diode laser 12 est de 5mW, ce qui permet de générer 4 faisceaux de 1,25mW.

Lorsque le substrat 6 est placé dans la nacelle de l'enceinte 3, les faisceaux incidents Fi traversent le substrat 6. Les faisceaux émergents Fe réceptionnés présentent une intensité lumineuse constante en fonction du temps.

Puis un traitement thermique est appliqué dans l'enceinte 3 de sorte à provoquer la fracture du substrat 6 au niveau du plan de fragilisation. Une contrainte mécanique apportée par exemple par une lame (non illustrée) au niveau du plan de fragilisation peut compléter l'effet du budget thermique appliqué au substrat 6 et finaliser l'amorce de la fracture. A l'instant où la fracture est initiée, une zone d'écartement C (ou coin d'air) apparait entre les deux portions 4,5 qui s'écartent, tel qu'illustré par agrandissement à la figure 1. Une fois amorcé, le front de fracture se déplace alors très vite le long du plan de fragilisation.

Le chemin des rayons y est illustré de façon simplifiée à la figure 1. Un faisceau émis Fi se divise au niveau du coin d'air. Une première partie du faisceau incident est directement transmis au travers la première portion 4, le coin d'air C et la deuxième portion 5, ce qui forme un premier faisceau émergent Fe. Du fait de la présence de la zone d'écartement C, une deuxième partie faisceau émis Fi est réfléchi au niveau de l'interface entre le coin d'air C et la deuxième portion 5, ce faisceau est à nouveau partiellement réfléchi au niveau de l'interface entre la première portion 4 et le coin d'air C ce qui forme un deuxième faisceau émergent Fe très proche du premier faisceau émergent Fe. Ces premier et deuxième faisceaux Fe interfèrent entre eux et les valeurs d'intensité lumineuse résultante de l'interférence sont reçus par les récepteurs 7. La différence de chemin optique entre les premier et deuxième faisceaux Fe correspond en première approximation à deux fois la distance entre les deux portions 4,5, soit deux fois l'épaisseur de la zone d'écartement C. Ainsi, lorsque le front de fracture ou la zone d'écartement C traverse un premier faisceau incident Fi, il engendre la formation d'une interférence reçue par le module de détection 8. Cette variation se traduit par une variation de l'intensité lumineuse reçue au niveau du photodétecteur 15 correspondant qui devient sinusoïdale et caractéristique d'un signal d'interférence. Cette variation permet d'identifier l'instant d'apparition de la zone d'écartement C et donc de la fracture au niveau du photodétecteur 15 concerné. La variation de l'intensité lumineuse est convertie en signal électrique qui est enregistré au niveau de l'oscilloscope 9 et transmis au processeur 11.

Au fur et à mesure de l'avancement du front de fracture entre les deux portions 4,5, le coin d'air C traverse successivement un deuxième faisceau incident Fi puis un troisième et un quatrième faisceau incident Fi de sorte qu'une variation d'intensité lumineuse est détectée successivement par des deuxième, troisième et quatrième photodétecteurs 15 correspondants. Ces variations d'intensité lumineuse sont converties en variations d'intensité de courant électrique que l'on peut par exemple observer sur l'écran de l'oscilloscope 9 pour une meilleure compréhension du phénomène.

La figure 2 représente un écran d'oscilloscope illustrant les signaux électriques qui lui ont été transmis par chacun des photodétecteurs 15, en fonction du temps. Le signal électrique F1 représenté dans la partie la plus haute de l'écran correspond à la variation de l'intensité du courant électrique et donc à la variation de l'intensité lumineuse détectée par un premier photodétecteur 15. Entre les valeurs de temps T de -10 et 0 microsecondes, l'intensité du courant électrique est constante car il n'y a pas de zone d'écartement C (ou coin d'air) au niveau de la zone fragile implantée. Lorsque T est à 0 microseconde, l'intensité du courant chute verticalement ce qui signifie que le coin d'air C a traversé le premier faisceau. Cette variation d'intensité permet la détection de l'apparition du coin d'air C par le premier photodétecteur 15 à une première position de détection.

Le signal électrique F2 représenté plus bas correspond à la variation de l'intensité lumineuse du deuxième faisceau émergent Fe. Avant un temps de 10 microsecondes, l'intensité est constante puis à 10 microsecondes l'intensité chute verticalement. Ceci a pour signification que le coin d'air C a traversé le deuxième faisceau incident Fi et a été détecté par le deuxième photodétecteur 15 à une deuxième position de détection. De même, l'apparition du coin d'air C a ensuite été détectée par le troisième photodétecteur 15 à 21 microsecondes (signal électrique F3) à une troisième position de détection puis par le quatrième photodétecteur 15 à 33 microsecondes (signal électrique F4) à une quatrième position de détection. Le système 2 permet ainsi de détecter les instants d'apparition du front de fracture in situ, à différentes positions de détection.

A partir de ces informations, le processeur 11 peut mesurer la différence de temps Δt entre un premier instant de détection de l'apparition du coin d'air C à une première position et un deuxième instant de détection de l'apparition du coin d'air C à une deuxième position de détection. Connaissant la distance entre les deux positions de détection, à savoir la distance des points sur le substrat 6 au niveau desquels les signaux pénètrent dans le substrat 6 ou la distance entre les deux faisceaux incidents Fi ou émergents Fe correspondants au niveau du substrat 6, le processeur 11 peut calculer la vitesse de propagation du coin d'air C et la vitesse du front de fracture dans l'ensemble du substrat 6 ou en différents points du substrat 6. Dans l'exemple ci dessus, la vitesse de propagation du front de fracture est de l'ordre de 1.5 km/s.

Par ailleurs, le processeur 11 peut également déterminer le temps écoulé entre deux maximums consécutifs Δm de chaque signal électrique. Sachant qu'entre les deux maximums Δm, l'écartement obtenu entre les deux portions 4,5 a évolué de la moitié de la longueur d'onde du faisceau incident Fi, le processeur 11 peut calculer la vitesse d'écartement des portions 4,5, et ce pour chaque position de détection.

De même, il est possible de déterminer la dynamique du profil d'écartement. En effet si l'on considère la zone d'écartement C comme un dièdre dont le sommet correspond au point de contact entre les surfaces de la première portion 4 et de la deuxième portion 5, plus l'intensité des oscillations est grande, plus le dièdre s'ouvre (plus l'angle à la base est important). Ainsi l'on observe que le lorsque le coin d'air apparait, le dièdre s'ouvre progressivement puis l'on observe un « rebroussement » correspondant des oscillations de plus en plus faibles amplitudes : les deux portions 4,5 après s'être écartées se resserrent du fait de la pression extérieure. Ensuite l'amplitude des oscillations augmentent à nouveau.

Ainsi le système 2 permet de déterminer plusieurs paramètres représentatifs des conditions de la propagation d'une zone d'écartement C. Ce système 2 permet en effet de détecter l'instant où la fracture est amorcée in situ dans l'enceinte 3 de fracture, la vitesse d'avancement du front de fracture et le profil d'écartement des portions 4,5 du substrat 6. A partir de ces informations, il est ensuite possible de déterminer l'intensité et la variation des contraintes soumises sur les portions 4,5 au cours de la fracture et également d'étudier et de déterminer le mécanisme de rupture.

Les portions 4,5 des substrats 6 observés peuvent être par exemple constituées de matériaux semiconducteurs, tel que le silicium, de céramiques ou de verres. Les matériaux des deux portions 4,5 peuvent être identiques ou différents selon la finalité souhaitée. Les première ou deuxième portions 4,5 peuvent également être constituées de deux matériaux collés entre eux, notamment pour obtenir un effet raidisseur lors du détachement d'un film mince au court d'un procédé Smart Cut™. Le matériau servant de raidisseur peut être transparent à la longueur d'onde utilisée de sorte que le système 2 peut fonctionner dans un mode de transmission.

Lorsque le matériau n'est pas transparent, celui-ci est de préférence utilisé dans la deuxième portion 5 du substrat 6 qui reçoit les faisceaux après la première portion 4. Le système de mesure 2 est alors adapté pour fonctionner dans un mode de réflexion, La figure 3 illustre le parcours simplifié et agrandi des faisceaux.

Dans ce deuxième exemple de fonctionnement du système de mesure 2 en mode de réflexion, le module d'émission 10 des faisceaux est placé du même coté du substrat 6 que le module de détection 8. Le système de mesure 2 observe la fracture d'un substrat 6 dont la première portion 4 est transparente à la longueur d'onde utilisée mais dont la deuxième portion 5 réfléchit le faisceau incident Fi.

Dans ce cas, une portion du faisceau incident Fi est réfléchie au niveau de l'interface entre le coin d'air C et la première portion 4 de sorte à former un faisceau émergent Fe. Une autre portion du faisceau incident Fi est réfléchie au niveau de l'interface entre le coin d'air C et la deuxième portion 5, ce qui forme un second faisceau émergent Fe. Les premier et deuxième faisceaux émergents Fe ainsi générés interfèrent et créent des franges d'interférences détectées par le module de détection 8. La différence de chemin optique entre ces premier et deuxième faisceaux Fe correspond en première approximation à deux fois la distance entre les deux portions 4,5, soit deux fois l'épaisseur de la zone d'écartement C.

Les autres éléments du système de mesure 2 de la figure 3 peuvent être similaires à ceux précédemment décrits. De la même façon que pour le premier exemple, le signal optique mesuré par le module de détection 8 est constant avant l'apparition de la fracture. Le signal commence à osciller lors de l'apparition de la zone d'écartement C. Après le passage du front de fracture, le calculateur 11 peut déterminer l'instant d'apparition de la fracture, Lorsque plusieurs faisceaux Fi sont émis (non illustré), il est également possible de mesurer la vitesse du front de fracture et le profil d'écartement des portions 4,5 de sorte à déterminer le mécanisme de fracture de la même façon que dans le premier exemple décrit.

La figure 4, illustre une partie d'un système de mesure 2 selon un troisième exemple sans agrandissement du trajet des différents faisceaux. Le dispositif fonctionne dans un mode de transmission en vue de la mesure de propagation d'une zone d'écartement C dans plusieurs substrats 6 en une seule étape de mesure. Sont notamment illustrés un module d'émission 10 de quatre faisceaux incidents Fi et un module de détection 8 correspondants en regard. Les autres parties du système 2 qui ne sont pas illustrées sur la figure 4 peuvent être identiques à celles représentées sur la figure 1.

Ce troisième exemple illustre le collage entre plusieurs premières portions 4 et plusieurs deuxièmes portions 5 de sorte à former plusieurs substrats 6. Les deux premières portions 4 et deux deuxièmes portions 5 sont mises en contact respectivement deux à deux dans une nacelle de l'enceinte 3 équipée de moyens adaptés pour induire le collage entre les portions. Les deux portions 4,5 sont en silicium de sorte qu'une diode laser infrarouge 12 ayant une longueur d'onde d'émission de 1310 nm peut être utilisée pour que le système de mesure 2 puisse fonctionner dans un mode de transmission.

En fonctionnement, chaque faisceau émis Fi par le module d'émission 10 traverse alors les première et deuxième portions 4,5 transparentes du premier substrat 6 puis les première et deuxième portions 4,5 transparentes du deuxième substrat 6. Chaque faisceau émergent Fe de l'ensemble des substrats 6 est alors ensuite reçu par un photodétecteur 15 du module de détection 8 qui le convertit en signal électrique pour un traitement par le calculateur 11. De la même façon que lors d'une fracture, l'intensité du signal optique varie selon la présence ou non d'un coin d'air entre chaque portion 4,5 et sa propagation. Il est alors possible de déterminer in situ, par des calculs appropriés, l'instant d'apparition du front de collage, la vitesse de la propagation du collage et le profil d'écartement (ou de rapprochement) des portions du substrat 6 au cours de l'avancement de l'onde de collage par interférométrie. Il est entendu ici que le profil d'écartement est mesuré sur une zone d'écartement entre les portions 4,5 qui diminue avec l'avancement du front de collage.

Ce système 2 permet ainsi de mesurer des paramètres des conditions de la propagation d'une zone d'écartement C lors du collage de deux portions 4,5 de plusieurs substrats 6, par une seule étape de mesure. Il est ainsi possible de déterminer la dynamique de collage.

Il est également possible de procéder de façon identique pour déterminer des paramètres de fracture de plusieurs substrats 6 en une seule étape de mesure.

Par ailleurs, le module d'émission 10 du système de mesure 2 peut émettre un nombre faisceaux Fi plus important de sorte à pouvoir adapter la mesure aux dimensions des substrats 6 à observer. De même, les modèles d'analyses peuvent être modifiés en fonction de la nature des matériaux des substrats 6.

Ainsi, la présente invention propose un système de mesure 2, un dispositif 1 adapté à la propagation d'une zone d'écartement C comprenant le système de mesure 2 et une méthode de mesure qui permettent de mesurer in situ des phénomènes de fracture ou de collage, aux vitesses de propagation très importantes. L'utilisation de faisceaux optiques permet de conserver de très grandes précision et sensibilité de mesure malgré la vitesse des phénomènes observés. Par ailleurs, la nature de la source lumineuse 12 peut être adaptée selon la nature du matériau à observer et il est possible d'obtenir des mesures sur plusieurs substrats 6 en une seule étape d'acquisition de données.

Il va de soi que l'invention n'est pas limitée aux modes de réalisation décrits ci-dessus à titre d'exemples mais qu'elle comprend tous les équivalents techniques et les variantes des moyens décrits ainsi que leurs combinaisons.

## Revendications

1. Système de mesure (2) de la propagation d'une zone d'écartement C entre une première portion (4) et une deuxième portion (5) d'au moins un substrat (6), le système (2) comprenant :
- un module d'émission (10) d'au moins deux faisceaux incidents Fi spatialement distincts illuminant chacun une région du substrat (6), ledit module d'émission (10) étant agencé de sorte que chacun des au moins deux faisceaux incidents Fi peut traverser la première portion (4), la zone d'écartement C et rencontrer la deuxième portion (5), de manière à générer chacun au moins un premier faisceau émergent Fe provenant de l'interface entre la première portion (4) et la zone d'écartement C, et au moins un deuxième faisceau émergent Fe provenant de l'interface entre la zone d'écartement C et la deuxième portion (5),
- un module de détection (8) d'intensité lumineuse, agencé de sorte à détecter les valeurs d'intensité lumineuse résultante en un point donné de l'interférence entre les premier et deuxième faisceaux émergents Fe, générés par chacun des au moins deux faisceaux incident Fi,
- un calculateur (11) agencé pour déterminer au moins un paramètre représentatif des conditions de la propagation de la zone d'écartement C à partir des variations temporelles de l'intensité lumineuse détectées par le module de détection (8).

2. Système de mesure (2) selon la revendication 1, **caractérisé en ce que** le module de détection (8) et le calculateur (11) sont configurés pour déterminer des vitesses de propagation de la zone d'écartement C entre les première et deuxième portions (4,5).

3. Système de mesure (2) selon l'une des revendications 1 à 2, **caractérisé en ce que** les au moins deux faisceaux incidents sont arrangés de sorte à être coplanaires afin de permettre la mesure de la propagation de la zone d'écartement C selon la direction du plan des faisceaux.

4. Système de mesure (2) selon l'une des revendications 1 à 3, **caractérisé en ce que** le module d'émission (10) comprend une source lumineuse (12) et au moins un coupleur (13), la source lumineuse (12) et ledit au moins un coupleur (13) étant agencés de sorte que ledit au moins un coupleur (13) peut séparer la lumière émise par la source lumineuse (12) en au moins deux faisceaux.

5. Système de mesure (2) selon la revendication 4, **caractérisé en ce que** le module d'émission (10) comprend au moins deux fibres optiques monomodes et au moins deux collimateurs (14), les fibres optiques étant adaptées à guider les faisceaux produits par ledit au moins un coupleur (13) respectivement jusqu'aux collimateurs (14), les collimateurs (14) étant adaptés à produire les au moins deux faisceaux incidents Fi.

6. Système de mesure (2) selon l'une des revendications 4 à 5, **caractérisé en ce que** la source lumineuse (12) est monochromatique et comprend notamment un laser, telle qu'une diode laser infrarouge.

7. Système de mesure (2) selon l'une des revendications 1 à 6, **caractérisé en ce que** le module d'émission (10) est agencé pour générer au moins deux faisceaux incidents Fi monochromatiques, cohérents et intenses de sorte que l'intensité lumineuse détectée soit supérieure au bruit de la mesure de détection (8).

8. Système de mesure (2) selon l'une des revendications 1 à 7, **caractérisé en ce qu'**au moins un faisceau incident Fi est sélectionné de sorte qu'au moins 10% de son intensité lumineuse peut être transmise à travers la première portion (4).

9. Système de mesure (2) selon la revendication 8, **caractérisé en ce que** le module d'émission (10) et le module de détection (8) sont agencés du même coté dudit au moins un substrat (6).

10. Système de mesure (2) selon la revendication 8 **caractérisé en ce que** ledit au moins un faisceau incident Fi est également sélectionné de sorte qu'au moins 10% de son intensité lumineuse peut être transmise à travers la deuxième portion (5) rencontrée par ledit au moins un faisceau incident Fi et **en ce que** le module d'émission (10) et le module de détection (8) sont agencés de part et d'autre dudit au moins un substrat (6).

11. Système de mesure (2) selon l'une des revendications 1 à 10, **caractérisé en ce que** le module de détection (8) comprend au moins un récepteur (7) d'intensité lumineuse et au moins un photodétecteur (15) de sorte à convertir les valeurs reçues d'intensité lumineuse résultante en un point donné de l'interférence entre les premier et deuxième faisceaux émergents Fe, en signal électrique.

12. Système de mesure (2) selon la revendication 11, **caractérisé en ce qu'**il comprend des moyens d'acquisition et d'enregistrement du signal électrique, tel qu'un dispositif d'échantillonnage (9), notamment un oscilloscope numérique ou une carte de conversion analogique numérique.

13. Dispositif (1) adapté à la propagation d'une zone d'écartement C entre une première portion (4) et une deuxième portion (5) d'au moins un substrat (6), **caractérisé en ce qu'**il comprend un banc de mesure (3), tel qu'un four, une machine de traction ou une machine d'essai, équipé de moyens adaptés à l'induction d'une fracture ou d'un collage entre la première portion (4) et la deuxième portion (5) et un système de mesure (2) de la propagation d'une zone d'écartement C selon l'une des revendications 1 à 12.

14. Procédé de mesure de la propagation d'une zone d'écartement C entre une première portion (4) et une deuxième portion (5) d'au moins un substrat (6), comprenant les étapes suivantes :
- émettre au moins deux faisceaux incidents Fi, illuminant chacun une région du substrat (6) et spatialement distincts de sorte à générer chacun au moins un premier faisceau émergent Fe provenant de l'interface entre la première portion (4) et la zone d'écartement C, et au moins un deuxième faisceau émergent Fe provenant de l'interface entre la zone d'écartement C et la deuxième portion (5),
- détecter les valeurs d'intensité lumineuse résultante en un point donné de l'interférence entre les premier et deuxième faisceaux émergents Fe à une première position de détection,
- détecter les valeurs d'intensité lumineuse résultante en un point donné de l'interférence entre les premier et deuxième faisceaux émergents Fe à une deuxième position de détection,
- mesurer la différence de temps entre un premier instant de détection de l'apparition de la zone d'écartement C au niveau de la première position de détection et un deuxième instant de détection de l'apparition de la zone d'écartement C au niveau de la deuxième position de détection, et
- déterminer la vitesse de propagation de la zone d'écartement C entre les première et deuxième portions (4,5) dudit au moins un substrat (6) en fonction de la distance entre les première et deuxième positions de détection et de la différence de temps entre les premier et deuxième instants de détection Δt.

15. Procédé de mesure selon la revendication 14, **caractérisé en ce qu'**il comprend en outre une étape consistant à déterminer le temps écoulé entre au moins deux maximums consécutifs Δm de l'intensité lumineuse détectée par un module de détection (8) de sorte à déterminer la vitesse de la propagation de la zone d'écartement C entre les première et deuxième portions (4,5).

16. Procédé de mesure selon l'une des revendications 13 à 15, **caractérisé en ce qu'**il comprend les étapes suivantes :
- mettre en oeuvre plusieurs substrats (6) transmettant au moins 10% de l'intensité lumineuse des faisceaux émis Fi, et
- émettre au moins un faisceau incident Fi de sorte à ce qu'il traverse chaque première portion (4), chaque deuxième portion (5) et chaque zone d'écartement C.

## Patentansprüche

1. Messsystem (2) der Ausbreitung einer Abstandszone C zwischen einem ersten Abschnitt (4) und einem zweiten Abschnitt (5) von mindestens einem Substrat (6), wobei das System (2) Folgendes umfasst:
- ein Emissionsmodul (10) von mindestens zwei räumlich getrennten einfallenden Strahlen Fi, jeweils einen Bereich des Substrats (6) beleuchtend, wobei das Emissionsmodul (10) so angeordnet ist, dass jeder der mindestens zwei einfallenden Strahlen Fi den ersten Abschnitt (4), die Abstandszone C durchqueren und den zweiten Abschnitt (5) so treffen kann, um jeweils mindestens einen ersten austretenden Strahl Fe, der aus der Grenzfläche zwischen dem ersten Abschnitt (4) und der Abstandszone C stammt, und mindestens einen zweiten austretenden Strahl Fe, der aus der Grenzfläche zwischen der Abstandszone C und dem zweiten Abschnitt (5) stammt, zu erzeugen,
- ein Lichtintensität-Detektionsmodul (8), so angeordnet, um die Werte der resultierenden Lichtintensität an einem gegebenen Punkt der Interferenz zwischen dem ersten und zweiten austretenden Strahl Fe, die durch jeden der mindestens zwei einfallenden Strahlen Fi erzeugt wurden, zu detektieren,
- einen Rechner (11), angeordnet zum Bestimmen von mindestens einem repräsentativen Parameter der Bedingungen der Ausbreitung der Abstandszone C, ausgehend von durch das Detektionsmodul (8) detektierten temporären Schwankungen der Lichtintensität.

2. Messsystem (2) nach Anspruch 1, **dadurch gekennzeichnet, dass** das Detektionsmodul (8) und der Rechner (11) konfiguriert sind, um die Ausbreitungsgeschwindigkeiten der Abstandszone C zwischen dem ersten und zweiten Abschnitt (4, 5) zu bestimmen.

3. Messsystem (2) nach einem der Ansprüche 1 bis 2, **dadurch gekennzeichnet, dass** die mindestens zwei einfallenden Strahlen so arrangiert sind, um koplanar zu sein, um die Messung der Ausbreitung der Abstandszone C entlang der Richtung der Ebene der Strahlen zu erlauben.

4. Messsystem (2) nach einem der Ansprüche 1 bis 3, **dadurch gekennzeichnet, dass** das Emissionsmodul (10) eine Lichtquelle (12) und mindestens einen Kuppler (13) umfasst, die Lichtquelle (12) und der mindestens eine Kuppler (13) so angeordnet sind, dass der mindestens eine Kuppler (13) das durch die Lichtquelle (12) emittierte Licht in mindestens zwei Strahlen aufteilen kann.

5. Messsystem (2) nach Anspruch 4, **dadurch gekennzeichnet, dass** das Emissionsmodul (10) mindestens zwei monomodige optische Fasern und mindestens zwei Kollimatoren (14) umfasst, die optischen Fasern dazu geeignet sind, die durch den mindestens einen Kuppler (13) produzierten Strahlen jeweils zu den Kollimatoren (14) zu leiten, wobei die Kollimatoren (14) geeignet sind, die mindestens zwei einfallenden Strahlen Fi zu produzieren.

6. Messsystem (2) nach einem der Ansprüche 4 bis 5, **dadurch gekennzeichnet, dass** die Lichtquelle (12) monochromatisch ist und insbesondere einen Laser, wie einen Infrarot-Diodenlaser, umfasst.

7. Messsystem (2) nach einem der Ansprüche 1 bis 6, **dadurch gekennzeichnet, dass** das Emissionsmodul (10) angeordnet ist, um mindestens zwei einfallende, monochromatische, kohärente und intensive Strahlen Fi so zu erzeugen, dass die detektierte Lichtintensität größer ist als das Messrauschen der Detektionsmessung (8).

8. Messsystem (2) nach einem der Ansprüche 1 bis 7, **dadurch gekennzeichnet, dass** mindestens ein einfallender Strahl Fi so ausgewählt wird, dass mindestens 10% seiner Lichtintensität durch den ersten Abschnitt (4) durchqueren kann.

9. Messsystem (2) nach Anspruch 8, **dadurch gekennzeichnet, dass** das Emissionsmodul (10) und das Detektionsmodul (8) auf der gleichen Seite des mindestens einen Substrats (6) angeordnet sind.

10. Messsystem (2) nach Anspruch 8, **dadurch gekennzeichnet, dass** der mindestens eine einfallende Strahl Fi ebenfalls so ausgewählt wird, dass mindestens 10% seiner Lichtintensität durch den zweiten Abschnitt (5), der von dem mindestens einen einfallenden Strahl Fi getroffen wird, durchqueren kann, und dadurch, dass das Emissionsmodul (10) und das Detektionsmodul (8) auf beiden Seiten des mindestens einen Substrats (6) angeordnet sind.

11. Messsystem (2) nach einem der Ansprüche 1 bis 10, **dadurch gekennzeichnet, dass** das Detektionsmodul (8) mindestens einen Lichtintensität-Rezeptor (7) und mindestens einen Photodetektor (15) umfasst, um so die erhaltenen Werte resultierender Lichtintensität an einem gegebenen Punkt der Interferenz zwischen dem ersten und zweiten austretenden Strahl Fe in elektrisches Signal umzuwandeln.

12. Messsystem (2) nach Anspruch 11, **dadurch gekennzeichnet, dass** es Erfassungs- und Registrierungsmittel des elektrischen Signals, wie eine Probenentnahmevorrichtung (9), umfasst, insbesondere ein numerisches Oszilloskop oder eine numerische analoge Umwandlungskarte.

13. Vorrichtung (1), geeignet zur Ausbreitung einer Abstandszone C zwischen einem ersten Abschnitt (4) und einem zweiten Abschnitt (5) von mindestens einem Substrat (6), **dadurch gekennzeichnet, dass** sie einen Messstand (3), wie einen Ofen, eine Zugmaschine oder eine Prüfmaschine, ausgestattet mit Mitteln, geeignet zur Induktion eines Bruchs oder einer Klebeverbindung zwischen dem ersten Abschnitt (4) und dem zweiten Abschnitt (5), und ein Messsystem (2) der Ausbreitung einer Abstandszone C nach einem der Ansprüche 1 bis 12, umfasst.

14. Messverfahren der Ausbreitung einer Abstandszone C zwischen einem ersten Abschnitt (4) und einem zweiten Abschnitt (5) von mindestens einem Substrat (6), das die folgenden Schritte umfasst:
- Emittieren von mindestens zwei einfallenden Strahlen Fi, jeweils einen Bereich des Substrats (6) beleuchtend und räumlich so getrennt, um jeweils mindestens einen ersten austretenden Strahl Fe, der aus der Grenzfläche zwischen dem ersten Abschnitt (4) und der Abstandszone C stammt, und mindestens einen zweiten austretenden Strahl Fe, der aus der Grenzfläche zwischen der Abstandszone C und dem zweiten Abschnitt (5) stammt, zu erzeugen,
- Detektieren der resultierenden Lichtintensitätswerte an einem gegebenen Punkt der Interferenz zwischen dem ersten und zweiten austretenden Strahl Fe an einer ersten Detektionsposition,
- Detektieren der resultierenden Lichtintensitätswerte an einem gegebenen Punkt der Interferenz zwischen dem ersten und zweiten austretenden Strahl Fe an einer zweiten Detektionsposition,
- Messen der Zeitdifferenz zwischen einem ersten Detektionsmoment des Erscheinens der Abstandszone C auf Höhe der ersten Detektionsposition und einem zweiten Detektionsmoment des Erscheinens der Abstandszone C auf Höhe der zweiten Detektionsposition, und
- Bestimmen der Ausbreitungsgeschwindigkeit der Abstandszone C zwischen dem ersten und zweiten Abschnitt (4, 5) des mindestens einen Substrats (6) als Funktion der Distanz zwischen der ersten und zweiten Detektionsposition und der Zeitdifferenz zwischen dem ersten und zweiten Detektionsmoment Δt.

15. Messverfahren nach Anspruch 14, **dadurch gekennzeichnet, dass** es des Weiteren einen Schritt umfasst, bestehend aus dem Bestimmen der zwischen mindestens zwei aufeinanderfolgenden Maxima Δm der durch ein Detektionsmodul (8) detektierten Lichtintensität vergangenen Zeit, um so die Geschwindigkeit der Ausbreitung der Abstandszone C zwischen dem ersten und zweiten Abschnitt (4, 5) zu bestimmen.

16. Messverfahren nach einem der Ansprüche 13 bis 15, **dadurch gekennzeichnet, dass** es die folgenden Schritte umfasst:
- Einsetzen mehrere Substrate (6), die mindestens 10% der Lichtintensität von emittierten Strahlen Fi durchlassen, und
- Emittieren von mindestens einem einfallenden Strahl Fi, sodass er jeden ersten Abschnitt (4), jeden zweiten Abschnitt (5) und jede Abstandszone C durchquert.

## Claims

1. A measuring system (2) for measuring the propagation of a spacing area C between a first portion (4) and a second portion (5) of at least one substrate (6), the system (2) comprising:
- an emitting module (10) for emitting at least two spatially distinct incident beams Fi each illuminating a region of the substrate (6), said emitting module (10) being arranged so that each of the at least two incident beams Fi is able to pass through the first portion (4), the spacing area C and meet the second portion (5), so as to generate each at least a first emergent beam Fe originating from the interface between the first portion (4) and the spacing area C, and at least a second emergent beam Fe originating from the interface between the spacing area C and the second portion (5),
- a detecting module (8) for detecting a light intensity arranged to detect the values of the resulting light intensity at a given point of the interference between the first and second emergent beams Fe, generated by each of the at least two incident beams Fi;
- a calculator (11) arranged to determine at least one parameter representative of the conditions of the propagation of the spacing area C from the temporal variations of the light intensity detected by the detecting module (8).

2. The measuring system (2) according to claim 1, **characterized in that** the detecting module (8) and the calculator (11) are configured to determine propagation speeds of the spacing area C between the first and second portions (4, 5).

3. The measuring system (2) according to any of claims 1 to 2, **characterized in that** the at least two incident beams are arranged to be coplanar in order to allow measuring the propagation of the spacing area C according to the direction of the plane of the beams.

4. The measuring system (2) according to any of claims 1 to 3, **characterized in that** the emitting module (10) comprises a light source (12) and at least one coupler (13), the light source (12) and said at least one coupler (13) being arranged such that said at least one coupler (13) can separate the light emitted by the light source (12) into at least two beams.

5. The measuring system (2) according to claim 4, **characterized in that** the emitting module (10) comprises at least two single-mode optical fibers and at least two collimators (14), the optical fibers being adapted to guide the beams produced by said at least one coupler (13) respectively to the collimators (14), the collimators (14) being adapted to produce the at least two incident beams Fi.

6. The measuring system (2) according to any of claims 4 to 5, **characterized in that** the light source (12) is monochromatic and comprises in particular a laser, such as an infrared laser diode.

7. The measuring system (2) according to any of claims 1 to 6, **characterized in that** the emitting module (10) is arranged to generate at least two monochromatic, coherent and intense incident beams Fi so that the detected light intensity is greater than the noise of the detection measurement (8).

8. The measuring system (2) according to any of claims 1 to 7, **characterized in that** at least one incident beam Fi is selected such that at least 10% of its light intensity can be transmitted through the first portion (4).

9. The measuring system (2) according to claim 8, **characterized in that** the emitting module (10) and the detecting module (8) are arranged on the same side of said at least one substrate (6).

10. The measuring system (2) according to claim 8 **characterized in that** said at least one incident beam Fi is also selected such that at least 10% of its light intensity can be emitted through the second portion (5) encountered by said at least one incident beam Fi and **in that** the emitting module (10) and the detecting module (8) are arranged on either side of said at least one substrate (6).

11. The measuring system (2) according to any of claims 1 to 10, **characterized in that** the detecting module (8) comprises at least one light intensity receiver (7) and at least one photodetector (15) so as to convert the received values of the resulting light intensity at a given point of the interference between the first and second emergent beams Fe, into an electrical signal.

12. The measuring system (2) according to claim 11, **characterized in that** it comprises means for acquiring and recording the electrical signal, such as a sampling device (9), in particular a digital oscilloscope or an analog-to-digital conversion board.

13. A device (1) adapted to the propagation of a spacing area C between a first portion (4) and a second portion (5) of at least one substrate (6), **characterized in that** it comprises a measuring bench (3), such as a furnace, a traction machine or a test machine, equipped with means adapted to the induction of a fracture or a bonding between the first portion (4) and the second portion (5) and a measuring system (2) for measuring the propagation of a spacing area C according to any of claims 1 to 12.

14. A method for measuring the propagation of a spacing area C between a first portion (4) and a second portion (5) of at least one substrate (6), comprising the following steps:
- emitting at least two incident beams Fi, each illuminating a region of the substrate (6) and spatially distinct so as to generate each at least a first emergent beam Fe originating from the interface between the first portion (4) and the spacing area C, and at least a second emergent beam Fe originating from the interface between the spacing area C and the second portion (5),
- detecting the values of the resulting light intensity at a given point of the interference between the first and second emergent beams Fe at a first detection position,
- detecting the values of the resulting light intensity at a given point of the interference between the first and second emergent beams Fe at a second detection position,
- measuring the difference in time between a first time of detection of the appearance of the spacing area C at the first detection position and a second time of detection of the appearance of the spacing area C at the second detection position, and
- determining the propagation speed of the spacing area C between the first and second portions (4, 5) of said at least one substrate (6) according to the distance between the first and second detection positions and to the difference in time between the first and second detection times Δt.

15. The measuring method according to claim 14, **characterized in that** it further comprises a step consisting in determining the time elapsed between at least two consecutive maxima Δm of the light intensity detected by a detecting module (8) so as to determine the speed of propagation of the spacing area C between the first and second portions (4, 5).

16. The measuring method according to any of claims 13 to 15, **characterized in that** it comprises the following steps:
- implementing a plurality of substrates (6) transmitting at least 10% of the light intensity of the emitted beams Fi, and
- emitting at least one incident beam Fi so that it passes through each first portion (4), each second portion (5) and each spacing area C.
